# DEMANDE DE BREVET EUROPEEN

(11) **EP 1 091 417 A1**
(43) Date de publication de la demande: **11.04.2001**
(21) Numéro de dépôt: 00402754.6
(22) Date de dépôt: 05.10.2000
(51) Int. Cl.: H01L 29/786, H01L 21/336

(54) **Procédé fabrication d'un dispositif semi-conducteur à grille enveloppante et dispositif obtenu**

(30) Priorité: 05.10.1999 FR 9912406
(71) Demandeur: STMicroelectronics S.A., 94250 Gentilly (FR)
(72) Inventeur: Skotnicki, Thomas, 38290 Crolles Montfort (FR); Jurczak, Malgorzata, 38000 Grenoble (FR)
(74) Mandataire: Dossmann, Gérard

(57) **Abrégé**

Le procédé comprend la formation par épitaxie sélective sur la surface de la région centrale active d'un substrat d'une couche de germanium ou alliage SiGe, la formation par épitaxie non sélective sur la couche de germanium ou d'alliage SiGe et sur la surface du substrat d'une couche de silicium, la gravure des couches pour former sur la région centrale active un empilement ayant deux flancs opposés laissant apparaître la couche de germanium ou d'alliage SiGe, l'élimination sélective du germanium ou de l'alliage SiGe pour former un tunnel, la formation d'une mince couche diélectrique sur les flancs et les surfaces extérieure et intérieure du tunnel et de la région centrale active du substrat, le dépôt d'un matériau conducteur recouvrant et comblant le tunnel et la gravure du matériau conducteur pour former une région de grille d'architecture enveloppante.

## Description

La présente invention concerne d'une manière générale un procédé de fabrication d'un dispositif semi-conducteur, tel qu'un transistor ayant une architecture de grille dite enveloppante (Gate All Around ou GAA).

L'architecture de grille GAA est particulièrement recherchée pour ses propriétés hors du commun en performances et en suppression des effets canaux courts. Ceci est dû au fait que le mince film de silicium constituant le canal du dispositif est entouré par la grille et se trouve sous le contrôle exclusif de celle-ci, ce qui supprime l'influence du champ de drain, éliminant ainsi les effets de canaux courts.

L'inversion volumique dans le film de silicium, ou au moins l'effet de deux canaux parallèles dans des films plus épais, conduit à un gain très net en performance pour une surface de silicium donnée.

Une telle architecture est décrite entre autre dans les documents "A new scaling methodology for the 0.1-0025 µm MOSFET (Une nouvelle méthodologie d'échelle pour le MOSFET 0,1-0,025 µm)", C. Fiegna, H. Iwai, T. Wada, T. Saito, E. Sangiorgi, B. Ricco, Symp. VLSI Techn. Dig., 1993, pages 33-34 ; "Comparative Study of Advanced MOSFET Concepts (Etude comparative de concepts avancés de MOSFET) ", IEEE Trans. Electron Devices, Vol. 43, n° 10, pages 1742-1753, 1996 ; et "Device Design Considerations for Double-Gate, Ground-Plane and Single-Gated Ultra-Thin SOI MOSFETs at the 25 nm Channel Length Generation (Considérations sur la conception de dispositif pour des MOSFETS SOI ultra-minces à double grille, plan-masse et grille unique de la génération à longueur de canal 25 nm)", Int. Electron Devices Meet. Tech. Dig., 1998, pages 407-410.

Malgré l'intérêt porté à cette architecture, il n'existe pas à l'heure actuelle de réalisations viables.

Les structures verticales d'architecture GAA telles celles décrites par T. Mizuno et al., Symposium on VLSI Technology, pages 23-24, 1988 et M. Terauchi et al., IEEE T. Electro Devices, pages 2303-2305, Décembre 1997, se heurtent à des problèmes technologiques et aux limitations imposées par les étapes de photo-

Pour bénéficier d'une architecture GAA, il faut des films très minces, de l'ordre de 10 nm, ce qui en orientation verticale correspond à la résolution de la photo lithogravure de la grille.

On a aussi proposé une orientation horizontale, mais la faisabilité et la qualité d'une épitaxie progressant dans un tunnel en matériau diélectrique, tel que proposé par H-S.P. Wong et al., IEDM Techn. Digest, pages 427-430, 1997, n'apparaît pas fiable.

La présente invention a donc pour objet de fournir un procédé de fabrication d'un dispositif semi-conducteur d'architecture GAA tel qu'un transistor, par exemple un MOSFET, qui soit simple et fiable.

Plus particulièrement, la présente invention a pour objet un procédé de fabrication d'un dispositif semi-conducteur d'architecture GAA qui comporte un enchaînement d'étapes simples, permet de réaliser des couches de silicium (canal) extrêmement minces (1-20 nm), bien contrôlées et reproductibles, supprime le besoin d'une photolithographie agressive et conduit à des capacités de jonction faibles (jonction sur isolant).

On atteint les buts ci-dessus, selon l'invention, en fournissant un procédé de fabrication d'un dispositif semi-conducteur d'architecture GAA, qui comprend les étapes suivantes :
(a) obtention d'un substrat comprenant une région centrale active en matériau semi-conducteur entourée par une région périphérique isolante en matériau diélectrique, lesdites régions comportant respectivement une surface principale active et une surface principale isolante coextensives constituant une surface principale du substrat ;
(b) formation par épitaxie sélective d'une couche de Ge ou d'un alliage SiGe monocristallin sur la surface principale active ;
(c) formation par épitaxie non sélective sur la couche de Ge ou d'alliage SiGe monocristallin et sur la surface principale isolante d'une couche de silicium qui est monocristallin dans sa partie reposant sur la couche Ge ou d'alliage SiGe monocristallin, et qui est polycristallin dans ses parties reposant sur la surface isolante ;
(d) masquage et gravure de la couche de silicium et de la couche de Ge ou d'alliage SiGe pour former sur la surface principale active un empilement comportant une couche de Ge ou SiGe monocristallin et une couche de silicium monocristallin et ayant deux flancs opposés laissant apparaître la couche de Ge ou d'alliage SiGe monocristallin ;
(e) élimination par gravure latérale sélective de la couche de Ge ou d'alliage SiGe, de sorte que la couche de silicium monocristallin de l'empilement forme une structure en pont sur la surface principale active, ladite structure en pont comportant des flancs, une surface externe et une surface interne définissant avec une partie correspondante de la surface principale active un tunnel ;
(f) formation sur les surfaces externe et interne de la structure en pont ainsi que sur ses flancs d'une mince couche d'un matériau diélectrique ne comblant pas le tunnel ;
(g) dépôt d'un matériau conducteur de manière à recouvrir la structure en pont et à remplir le tunnel ; et
(h) masquage et la gravure du matériau conducteur pour former une région de grille d'architecture GAA, de dimension et géométrie voulues.

Le matériau semi-conducteur du substrat est de préférence du silicium.

Comme cela est bien connu, la couche de silicium formée à l'étape (c), dans la région qui par la suite constituera le canal du dispositif semi-conducteur, peut être dopée, consécutivement N et P, comme dans le procédé conventionnel. Ce dopage peut être effectué in situ au cours de la croissance épitaxiale non sélective de la couche de silicium ou peut être réalisé après formation de la couche épitaxiale de silicium par masquage et implantation ionique.

La couche de silicium de l'étape (c) est constituée de silicium monocristallin sur la couche de Ge ou alliage SiGe et de silicium polycristallin sur la surface principale isolante. L'épaisseur de cette couche de silicium peut être différente sur la couche de Ge ou d'alliage SiGe et sur la surface principale isolante. En particulier, elle peut être beaucoup plus épaisse sur la surface principale isolante, ce qui est bénéfique pour les résistances séries ainsi que pour les étapes de siliciuration des jonctions. En général, cette couche de silicium a une épaisseur variant de 1 à 50 nm, et a en général une épaisseur de l'ordre de 20 nm.

La formation de la couche de matériau diélectrique de l'étape (f) peut se faire par oxydation thermique de la couche de silicium ou par dépôt classique d'un matériau diélectrique. On peut utiliser tout matériau diélectrique approprié, mais on utilise de préférence SiO. De préférence, la couche de SiO est formée par oxydation thermique de la couche de silicium.

Les alliages SiGe sont des alliages bien connus.

Parmi ces alliages, on peut citer les alliages Si₁₋ₓGeₓ où 0 < x < 1 et Si_{1-x-y}GeₓCy où 0 < x ≤ 0,95 et 0 < y ≤ 0,05. De préférence, on utilisera un alliage SiGe comportant un taux de Ge (x ≥ 0,05, de préférence 0,20 ≤ x ≤ 0,30), car la sélectivité de la gravure par rapport à Si augmente avec l'accroissement du taux de Ge dans l'alliage.

Comme cela est également bien connu, Ge et les alliages SiGe sont aisément sélectivement éliminables, soit au moyen d'une chimie oxydante telle que par attaque avec une solution 40 ml HNO₃ 70% + 20 ml H₂O₂ + 5 ml HF 0,5%, soit par attaque plasma isotrope.

La couche de Ge ou d'alliage SiGe a une épaisseur qui peut varier de quelques nanomètres à 50 nm, et en général de l'ordre de 20 nm.

Le matériau conducteur de l'étape (g) peut être un métal, mais est de préférence du silicium polycristallin. Dans le cas du silicium, celui-ci est de préférence dopé in situ. La gravure de ce matériau conducteur pour former la grille d'architecture GAA s'effectue au moyen de tout procédé classique de photolithographie de grille.

Des résidus du matériau à l'intérieur du tunnel ne sont pas gênants pour le fonctionnement du dispositif, si ce n'est une légère augmentation des capacités de recouvrement grille-drain et grille-source. Toutefois, ces capacités parasites peuvent être réduites moyennant des règles de dessins serrées pour la distance grille-bord d'isolement.

L'implantation des régions de source et de drain précédée éventuellement de la formation d'espaceurs et d'extensions (LDD), peut se faire de manière classique et être suivie d'un recuit d'activation classique et d'une siliciuration.

La couche de silicium au-dessus du tunnel présente une parfaite structure monocristalline et une uniformité d'épaisseur.

Les défauts qui apparaissent dans la couche de silicium au bord de la région périphérique isolante (passage de Si monocristallin à Si polycristallin) n'influencent pas le canal du dispositif car sur deux flancs opposés, ils sont retranchés par la gravure de la couche et sur les deux autres côtés, ils se situent à l'intérieur des jonctions source-drain à l'écart du canal.

Le fait que l'alliage SiGe soit éliminé juste après sa formation et l'étape de photogravure, sans aucune étape thermique entre les deux, favorise la stabilité et autorise des épaisseurs plus grandes. Ceci confère une plus grande liberté pour ce qui est des étapes thermiques ultérieures, car il n'y a plus de risque de relaxation de la couche d'alliage SiGe.

La présente invention concerne également un dispositif semi-conducteur à grille enveloppante qui comprend un substrat ayant une région centrale active en matériau semi-conducteur entourée d'une région périphérique isolante en matériau diélectrique, lesdites régions ayant respectivement une surface principale active et une surface principale isolante coextensives constituant une surface principale du substrat, caractérisé en ce qu'il comprend sur la surface principale du substrat une structure en pont constituée de silicium et ayant deux parties latérales opposées en silicium polycristallin reposant sur des parties opposées de la région périphérique isolante constituant les régions de source et de drain et réunies par une mince partie centrale en silicium monocristallin espacée au-dessus de ladite région active du substrat constituant une région de canal du dispositif, et une région de grille entourant la mince partie centrale de la structure en pont.

La mince partie centrale, en silicium monocristallin, a une épaisseur qui varie de 1 à 50 nm et elle est espacée de la surface principale de la région centrale active d'une hauteur généralement de l'ordre de 1 à 50 nm.

En outre, les contacts de source et de drain sont formés sur les parties latérales de la structure en pont au-dessus des parties opposées de la région périphérique isolante.

Enfin, la région de grille se prolonge jusque sur la région périphérique isolante et le contact de grille est également formé au-dessus de la région périphérique isolante.

Le dispositif semi-conducteur est de préférence un transistor.

La suite de la description se réfère aux figures annexées, qui représentent respectivement :

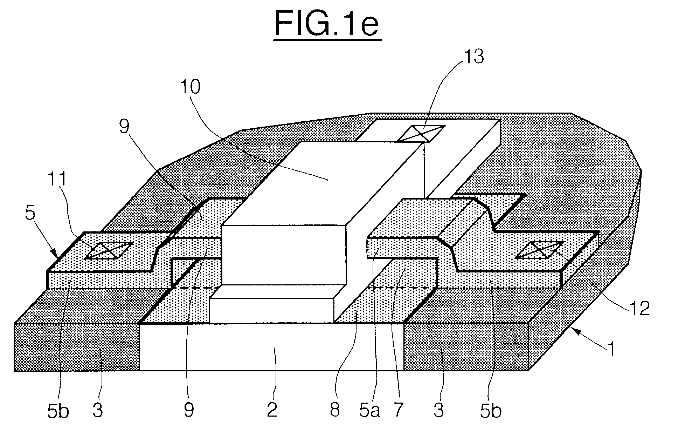

Figures 1a à 1e - des représentations schématiques des principales étapes d'une réalisation du procédé de l'invention.

Le procédé de l'invention débute, comme le montre la figure la, par le dépôt par épitaxie sélective sur une surface principale d'une région centrale active 2 en silicium d'un substrat 1 d'une couche 4 d'un alliage SiGe monocristallin sur une épaisseur comprise entre 1 et 50 nm. La région centrale active 2 du substrat 1 est entourée d'une région périphérique isolante 3.

La couche d'alliage SiGe ainsi que la surface principale de la région périphérique isolante, sont recouvertes par épitaxie non sélective d'une couche de silicium 5 formant ainsi une structure en forme de pont de très faible épaisseur comprise entre 1 et 50 nm et de préférence entre 1 et 20 nm. La couche 5 de silicium est monocristalline dans sa partie centrale 5a de la zone active (cette partie formera le canal du transistor), et polycristalline dans ses parties 5b qui reposent sur l'isolant (ces parties formeront les régions de source et de drain du dispositif).

Cette couche de silicium est alors dopée par masquage et implantation ionique de manière classique dans la zone qui, par la suite, constituera le canal du transistor.

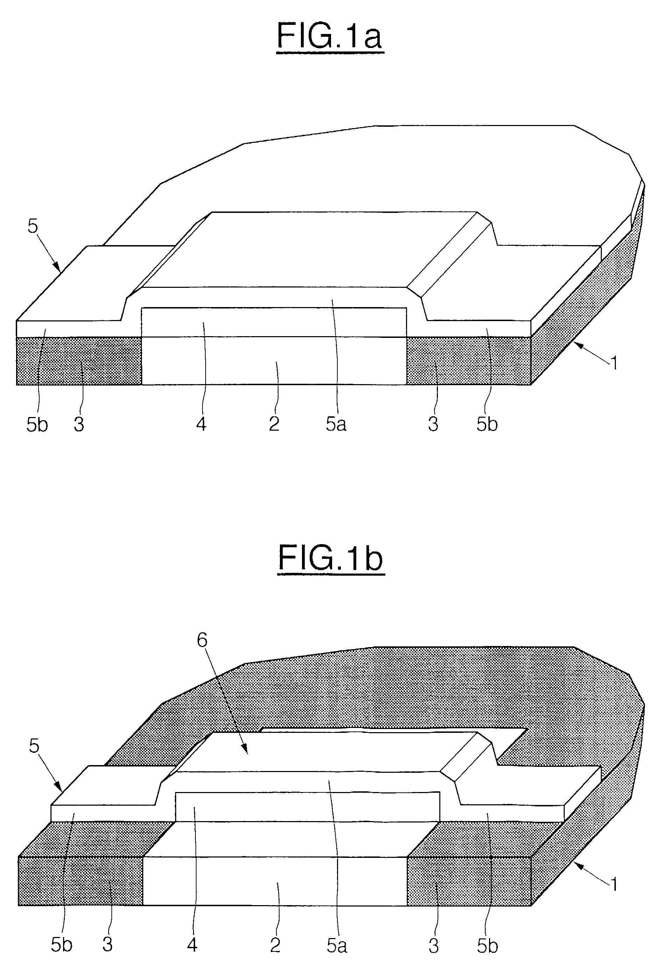

On procède alors, comme représenté à la figure 1b, au masquage et à la gravure de la couche de silicium 5 et de la couche d'alliage SiGe 4, de manière à former sur la surface principale de la région centrale active 2 du substrat 1 un empilement 6 des couches d'alliage SiGe monocristallin 4 et de silicium monocristallin 5a ayant deux flancs opposés sur la région centrale active 2 laissant apparaître la couche d'alliage SiGe monocristallin 4.

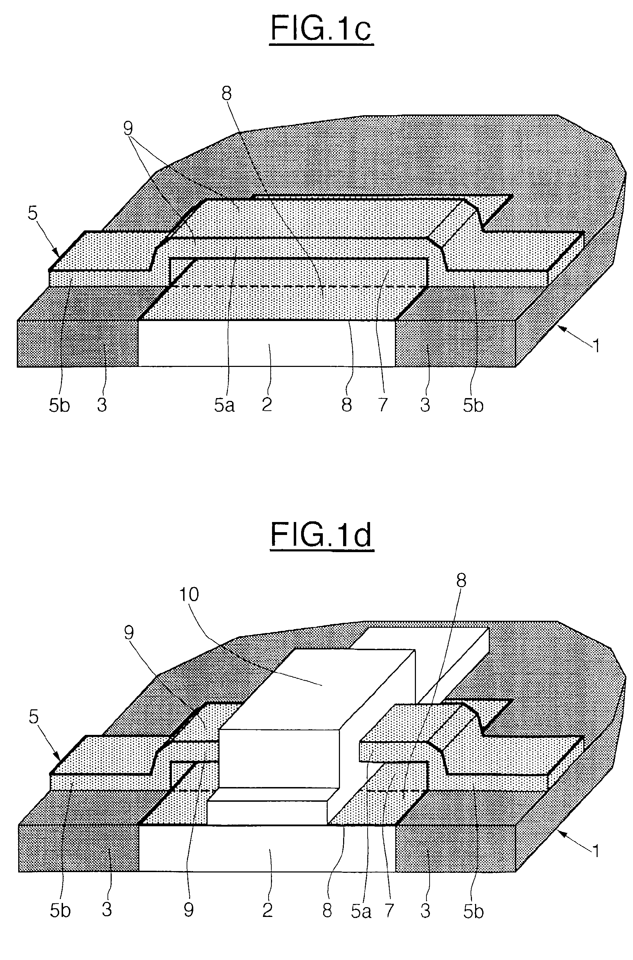

On procède à la gravure sélective de la couche d'alliage SiGe 4 pour former le tunnel 7 (figure 1c), par exemple au moyen de la solution oxydante mentionnée ci-dessus. La hauteur du tunnel 7 correspond à l'épaisseur de la couche 4 et est donc comprise entre 1 et 50 nm.

Comme le montre la figure 1c, on forme, par exemple par oxydation thermique, une mince couche 8 d'oxyde de silicium sur la surface principale de la région centrale active 2 et la surface interne du tunnel 7, en évitant de combler le tunnel 7. Cette même étape d'oxydation thermique conduit également au recouvrement de la surface externe et des flancs de la structure en pont par une couche d'oxyde de silicium 9.

On dépose alors de manière classique une couche de silicium polycristallin de façon à recouvrir toute la surface principale du substrat 1 et combler le tunnel 7. Cette couche de silicium polycristallin est de préférence dopée in situ de manière classique.

On grave ensuite, comme le montre la figure 1d, la couche de silicium polycristallin en utilisant des techniques de photo lithogravure classiques pour former la grille d'architecture GAA 10.

On forme ensuite, de manière classique, comme représenté à la figure le, les régions de source et de drain par implantation ionique, et on les équipe, ainsi que la région de grille des contacts, notes : 11 pour la source, 12 pour le drain et 13 pour la grille.

Le dispositif semi-conducteur, tel qu'un transistor, est alors achevé de manière classique.

## Revendications

1. Procédé de fabrication d'un dispositif semi-conducteur d'architecture à grille enveloppante, caractérisé en ce qu'il comprend les étapes suivantes :
(a) obtention d'un substrat comprenant une région centrale active (2) en matériau semi-conducteur entourée par une région périphérique isolante (3) en matériau diélectrique, lesdites régions comportant respectivement une surface principale active et une surface principale isolante coextensives constituant une surface principale du substrat ;
(b) par épitaxie sélective d'une couche de Ge ou d'un alliage SiGe moncristallin (4) sur la surface principale active ;
(c) formation par épitaxie non sélective sur la couche de Ge ou d'alliage SiGe monocristallin et sur la surface principale isolante d'une couche de silicium (5) qui est monocristalline dans sa partie reposant sur la couche Ge ou d'alliage SiGe monocristallin, et qui est polycristalline dans ses parties reposant sur la surface isolante ;
(d) masquage et gravure de la couche de silicium (5) et de la couche de Ge ou d'alliage SiGe (4) pour former sur la surface principale active un empilement (6) ayant deux flancs opposés laissant apparaître la couche de Ge ou d'alliage SiGe monocristallin ;
(e) élimination par gravure sélective de la couche de Ge ou d'alliage SiGe monocristallin, de sorte que la couche de silicium de l'empilement forme une structure en pont sur la surface principale active, ladite structure en pont comportant des flancs, une surface externe et une surface interne définissant avec une partie correspondante de la surface principale active un tunnel (7) ;
(f) formation sur les surfaces externe et interne de la structure en pont ainsi que sur ses flancs d'une mince couche d'un matériau diélectrique (8, 9) ne comblant pas le tunnel ;
(g) dépôt d'un matériau conducteur de manière à recouvrir la structure en pont et à remplir le tunnel ; et
(h) le masquage et la gravure du matériau conducteur pour former une région de grille (10) d'architecture enveloppante, de dimension et géométrie voulues.

2. Procédé selon la revendication 1, caractérisé en ce qu'il comprend avant l'étape (d) une étape de dopage de la couche de silicium (5).

3. Procédé selon la revendication 2, caractérisé en ce que le dopage s'effectue in situ lors du dépôt de la couche de silicium (5).

4. Procédé selon la revendication 2, caractérisé en ce que le dopage s'effectue par l'implantation ionique après formation de la couche de silicium (5).

5. Procédé selon l'une quelconque des revendications 1 à 4, caractérisé en ce que la région centrale active (2) du substrat (1) est en silicium.

6. Procédé selon l'une quelconque des revendications précédentes, caractérisé en ce que le matériau conducteur de l'étape (g) est un métal ou du silicium polycristallin.

7. Procédé selon l'une quelconque des revendications précédentes, caractérisé en ce que le dispositif semi-conducteur est un transistor.

8. Dispositif semi-conducteur comprenant un substrat (1) ayant une région centrale active (2) en matériau semi-conducteur entourée d'une région périphérique isolante (3) en matériau diélectrique, lesdites régions ayant respectivement une surface principale active et une surface principale isolante coextensive constituant une surface principale du substrat, ladite surface principale du substrat présentant une structure en pont (5) constituée de silicium et ayant deux parties latérales opposées en silicium polycristallin (5b) reposant sur des parties opposées de la région périphérique isolante constituant des régions de source et de drain et réunies par une partie centrale (5a) espacée au-dessus de ladite région active du substrat constituant une région de canal du dispositif, une région de grille (10) entourant la partie centrale de la structure en pont caractérisé en ce que ladite partie centrale (5a) est en silicium monocristallin et présente une épaisseur comprise entre 1 à 50 nm.

9. Dispositif selon la revendication 8, caractérisé en ce que l'épaisseur de la partie centrale varie de 1 à 20 nm.

10. Dispositif selon la revendication 8, caractérisé en ce que la partie centrale est espacée de la surface principale de la région centrale active du substrat d'une hauteur de 1 à 50 nm.

11. Dispositif selon l'une quelconque des revendications 8 à 10, caractérisé en ce que des contacts de source et de drain sont disposés sur les parties latérales en silicium polycristallin de la structure en pont au-dessus de la région périphérique isolante.

12. Dispositif selon l'une quelconque des revendications 8 à 11, caractérisé en ce que le dispositif est un transistor.
